# EUROPEAN PATENT SPECIFICATION

(11) **EP 3 163 631 B1**
(45) Date of publication and mention of the grant of the patent: **06.01.2021**
(21) Application number: 15811905.7
(22) Date of filing: 22.06.2015
(51) Int. Cl.: C08K 5/3492, C08K 5/5425, C08L 23/08, H01L 31/048

(54) **RESIN COMPOSITION FOR SOLAR CELL ENCAPSULATING MATERIAL, SOLAR CELL ENCAPSULATING MATERIAL, AND SOLAR CELL MODULE**
HARZZUSAMMENSETZUNG FÜR SOLARZELLENDICHTUNGSMATERIALIEN, SOLARZELLENDICHTUNGSMATERIAL UND SOLARZELLENMODUL
COMPOSITION DE RÉSINE POUR MATÉRIAU DE SCELLEMENT DE CELLULE SOLAIRE, MATÉRIAU DE SCELLEMENT DE CELLULE SOLAIRE, ET MODULES DE CELLULES SOLAIRES

(30) Priority: 27.06.2014 JP 2014133114
(43) Date of publication of application: 03.05.2017
(73) Proprietor: Mitsui Chemicals Tohcello, Inc., Tokyo 101-8485 (JP)
(72) Inventor: MUROFUSHI Takanobu, Hitachinaka-shi Ibaraki 312-0002 (JP); TOKUHIRO Jun, Hitachinaka-shi Ibaraki 312-0002 (JP)
(74) Representative: Hoffmann Eitle
(86) International application number: PCT/JP2015/067887
(87) International publication number: WO 2015/199029

(56) References cited:
- WO-A1-2012/118160
- JP-A- 2010 074 180
- JP-A- 2012 071 420
- JP-A- 2012 214 788
- JP-A- 2014 107 288
- US-A1- 2013 137 833
- DATABASE WPI Week 201279 Thomson Scientific, London, GB; AN 2012-P86170 XP002777055, -& JP 2012 227453 A (MITSUI CHEM INC) 15 November 2012 (2012-11-15)

## Description

### TECHNICAL FIELD

The present invention relates to a resin composition for a solar-cell encapsulating material, a solar-cell encapsulating material, and a solar cell module.

### BACKGROUND ART

Global environmental problems, energy problems, and the like become more serious, and thus a solar cell attracts attention as energy generation means that is clean and has no concern about exhaustion. In a case where a solar cell is used outside, for example, in the roof of a building, the solar cell is generally used in a form of a solar cell module.

Generally, a solar cell module is manufactured through the following procedures.

Firstly, a crystalline solar cell element or a thin-film solar cell element (crystalline solar cell element and thin-film solar cell element may be collectively simply referred to as "a solar cell element" or "a cell" below) is manufactured. The crystalline solar cell element is formed of polycrystalline silicon, single crystal silicon, and the like. The thin-film solar cell element is obtained by forming a very thin film of several µm such as amorphous silicon or crystalline silicon on a substrate such as glass.

Then, in order to obtain a crystalline solar cell module, a protective sheet for a solar cell module (front surface-side transparent protection member), a solar-cell encapsulating material sheet (sheet-like solar-cell encapsulating material is also referred below to as a solar-cell encapsulating material sheet), a crystalline solar cell element, a solar-cell encapsulating material sheet, and a protective sheet for a solar cell module (back surface-side protection member) are stacked in this order.

In order to obtain a thin-film type solar cell module, a thin-film solar cell element, a solar-cell encapsulating material sheet, and a protective sheet for a solar cell module (back surface-side protection member) are stacked in this order.

Then, a solar cell module is manufactured by using a lamination method in which vacuum aspiration is performed on the above components, and thermal press bonding is performed. The solar cell module manufactured in this manner is weather resistant, and is suitable for being used outside, for example, in the roof of a building.

Generally, an ethylene·vinyl acetate copolymer, an ethylene·α-olefin copolymer, or the like is used for the above-described solar-cell encapsulating material sheet. Since long-term weather resistance is required for the solar-cell encapsulating material, a photostabilizer is normally included as an additive. Considering adhesion with the front surface-side transparent protection member and the back surface-side protection member which are represented as glass, a silane coupling agent is also normally included in the solar-cell encapsulating material.

An ethylene-vinyl acetate copolymer (EVA) sheet as a solar-cell encapsulating material is excellent in transparency, flexibility, adhesiveness, and the like, and thus has been widely used in the related art. For example, Patent Document 1 (Japanese Laid-open Patent Publication No. 2010-53298) discloses an encapsulating film which is formed of an EVA composition containing a cross-linking agent and trimellitic acid ester, and is excellent in both of adhesiveness and film forming properties.

However, in a case where the EVA composition is used as a constituent material of the solar-cell encapsulating material, a component such as an acetic acid gas, generated by breaking EVA down, may affect a solar cell element.

On the one hand, using a polyolefin-based material, particularly, a polyethylene-based material as the solar-cell encapsulating material has been proposed from a viewpoint of excellent insulating properties (for example, see Patent Document 2).

A resin composition for the solar-cell encapsulating material, which uses an ethylene·α-olefin copolymer has been also proposed (for example, see Patent Document 3). In the resin composition, cross-linking is performed for a relatively short term and sufficient adhesive strength is obtained. The resin composition has excellent balance between rigidity and cross-linking characteristics.

However, according to an examination of the present inventors, when the solar-cell encapsulating material using an ethylene·α-olefin copolymer has excessively high fluidity, the solar-cell encapsulating material is extruded when lamination is performed, and thus a laminating device gets messy and cleaning is required. Thus, delay of a process is caused. In addition, when the solar-cell encapsulating material on the back side is colored, the solar-cell encapsulating material on the back side is wrapped around the front side of a solar cell, and thus the appearance of the solar cell becomes worse.

A solar-cell encapsulating material using an ethylene·α-olefin copolymer which has low fluidity and a low melt flow rate (MFR) has been proposed.US 2013/137833 A1 describes a resin composition for a solar cell encapsulant characterized by containing the ethylene·α-olefin copolymer (A) having the characteristics of the following (a1) to (a5), and an organic peroxide (B) and/or a silane coupling agent (C). (a1) a density of 0.860 to 0.920 g/cm³ (a2) a ratio (Mz/Mn) of Z average molecular weight (Mz) and number average molecular weight (Mn) determined by a gel permeation chromatography (GPC), of 8.0 or less (a3) a melt viscosity (η*₁) measured at 100° C. under a shear rate of 2.43×10 s⁻¹ of 1.2×10⁵ poise or more (a4) a melt viscosity (η*₂) measured at 100° C under a shear rate of 2.43×102 s⁻¹ of 2.0×10⁴ poise or more (a5) a branch number (N) derived from a comonomer in a polymer satisfying the expression (a).

JP 2012-227453 A describes a solar cell sealant characterized in that 100 parts by weight of ethylene α-olefin copolymer satisfying the following requirements a1) and a2), contains 0.01 to 1.0 parts by weight of a low molecular weight hindered amine type light stabilizer represented by a following general formula (1) and 0.01 to 1.0 parts by weight of a high molecular weight hindered amine type light stabilizer; and a1) : a Shore A hardness measured in accordance with ASTM D2240 is 60 to 85, and a2): a MFR at 190°C and under the load of 2.16 kg measured in accordance with ASTM D1238 is 10 to 50 g/10 minutes. 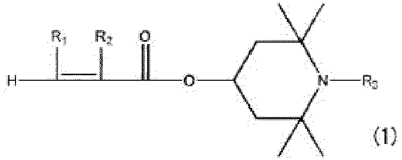 In the general formula (1), R₁ and R₂ represent hydrogen or an alkyl group, R₁ and R₂ may be the same or different, and R₃ represents hydrogen, an alkyl group or an alkenyl group.

### RELATED DOCUMENT

### PATENT DOCUMENT

[Patent Document 1] Japanese Laid-open Patent Publication No. 2010-53298
[Patent Document 2] Japanese Laid-open Patent Publication No. 2006-210906
[Patent Document 3] International Publication No. WO 2011/162324

### SUMMARY OF THE INVENTION

However, according to an examination of the present inventors, it has become clear that adhesiveness is gradually reduced for a period after molding until being laminated, in the solar-cell encapsulating material using an ethylene·α-olefin copolymer of the low MFR type.

Considering the above circumstances, the present invention is to provide a resin composition for a solar-cell encapsulating material which can obtain a solar-cell encapsulating material having excellent preservation stability, and has an ethylene·α-olefin copolymer of the low MFR type as a base.

The present inventors performed close investigation for achieving the above objects. As a result, the present inventors recognized that a specific hindered amine-based photostabilizer is combined with an ethylene·α-olefin copolymer of the low MFR type and a silane coupling agent, and thus longitudinal stability in adhesiveness of the obtained solar-cell encapsulating material is improved, and thus the present invention has been completed.

That is, according to the present invention, a resin composition for a solar-cell encapsulating material, a solar-cell encapsulating material, and a solar cell module, which are described in the following descriptions are provided.
[1] There is provided a resin composition for a solar-cell encapsulating material which includes an ethylene·α-olefin copolymer of which an MFR measured based on ASTM D1238 under conditions of 190°C and a load of 2.16 kg is equal to or more than 2.0 g/10 minutes and equal to or less than 9.0 g/10 minutes, a silane coupling agent, and a hindered amine-based photostabilizer. pH of the hindered amine-based photostabilizer, which is measured by using the following measuring method is equal to or less than 9.0. In the measuring method, the pH is measured by using a potential difference measuring device and by using a solution which contains 10 g of acetone, 1 g of water, and 0.01 g of the hindered amine-based photostabilizer, as a sample.
   In the resin composition for a solar-cell encapsulating material, the hindered amine-based photostabilizer includes one type, or two or more types which are selected from a group consisting of compounds indicated by the following Formulae (1) to (4). 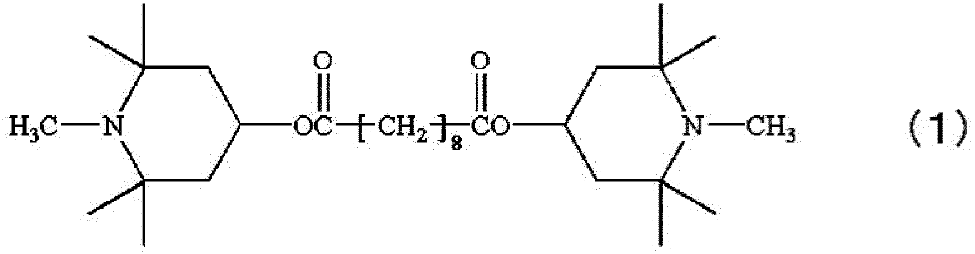 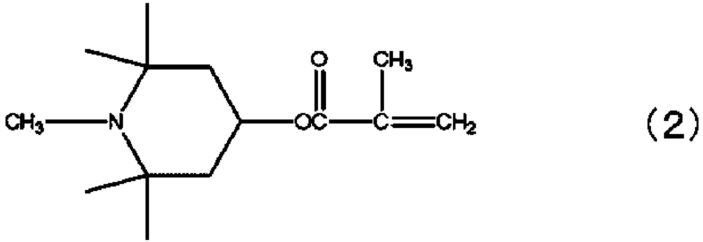 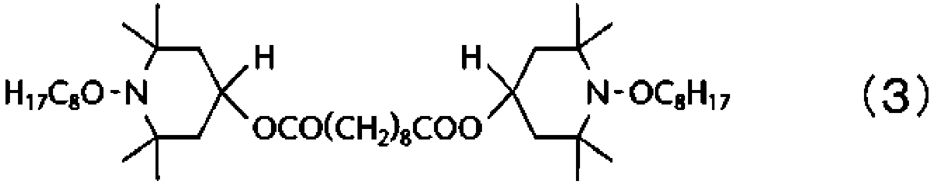 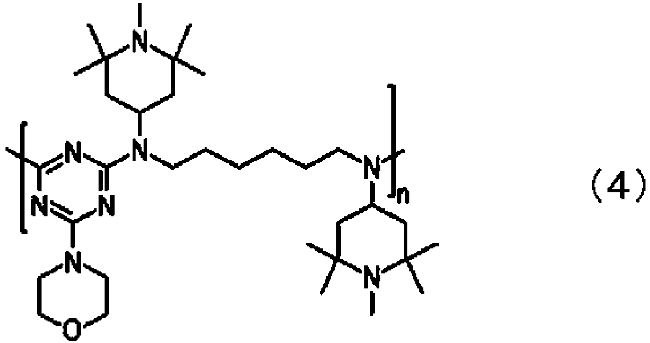
[2] In the resin composition for a solar-cell encapsulating material in [1], the ethylene·α-olefin copolymer further satisfies the following requirements a1) to a3).
   a1) a content percentage of a constituent unit derived from ethylene is 80 to 90 mol%, and a content percentage of a constituent unit derived from α-olefin having 3 to 20 carbon atoms is 10 to 20 mol%
   a2) density measured based on ASTM D1505 is 0.865 to 0.884 g/cm³
   a3) Shore A hardness measured based on ASTM D2240 is 60 to 85
[3] In the resin composition for a solar-cell encapsulating material in [1] or [2], the content of the hindered amine-based photostabilizer in the resin composition for a solar-cell encapsulating material is equal to or more than 0.01 parts by mass and equal to or less than 1 part by mass, with respect to 100 parts by mass of the ethylene·α-olefin copolymer.
[4] In the resin composition for a solar-cell encapsulating material in any one of [1] to [3], the content of the silane coupling agent in the resin composition for a solar-cell encapsulating material is equal to or more than 0.01 parts by mass and equal to or less than 5 parts by mass, with respect to 100 parts by mass of the ethylene·α-olefin copolymer.
[5] In the resin composition for a solar-cell encapsulating material in any one of [1] to [4], the silane coupling agent includes at least one type selected from 3-methacryloxypropyl trimethoxy silane and 3-acryloxypropyl trimethoxy silane.
[6] There is provided a solar-cell encapsulating material formed of the resin composition for a solar-cell encapsulating material in any one of [1] to [5].
[7] The solar-cell encapsulating material in [6] has a sheet shape.
[8] In the solar-cell encapsulating material in [6] or [7], the specific volume resistivity of the cross-linked solar-cell encapsulating material, which is measured at a temperature of 60°C and an applied voltage of 1000 V, based on JIS K6911 is equal to or more than 1.0X10¹⁶ Ω·cm.
[9] There is provided a solar cell module which includes a front surface-side transparent protection member, a back surface-side protection member, a solar cell element, and an encapsulating layer which is formed by performing crosslinking on the solar-cell encapsulating material in [6] to [8], and encapsulates the solar cell element between the front surface-side transparent protection member and the back surface-side protection member.

According to the present invention, it is possible to provide a resin composition for a solar-cell encapsulating material which can obtain a solar-cell encapsulating material having excellent preservation stability, and has an ethylene·α-olefin copolymer of the low MFR type as a base, and to provide a solar-cell encapsulating material having excellent preservation stability.

According to the present invention, it is possible to provide a solar cell module having excellent preservation stability, by using such a solar-cell encapsulating material.

### BRIEF DESCRIPTION OF THE DRAWING

The object and other objects, features and advantages which are described above are clarified by a desired embodiment which will be described below, and the following accompanying drawing.

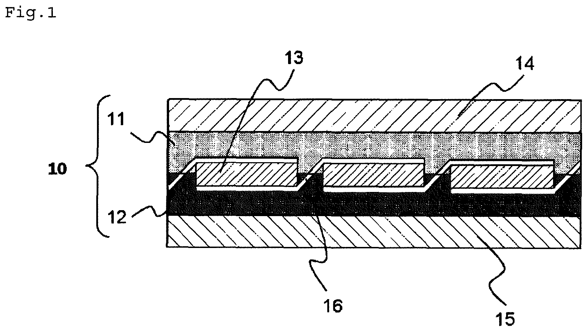

FIG. 1 is a sectional view schematically illustrating a representative embodiment of a solar cell module according to the present invention.

### DESCRIPTION OF EMBODIMENTS

Hereinafter, an embodiment according to the present invention will be described with reference to the drawings. "A to B" in a numerical range means being equal to or greater than A and equal to or smaller than B as long as there is no particular statement about "A to B".

### [Resin Composition for Solar-Cell Encapsulating Material]

A resin composition for a solar-cell encapsulating material according to an embodiment includes an ethylene·α-olefin copolymer of which an MFR measured based on ASTM D1238 under conditions of 190°C and a load of 2.16 kg is equal to or more than 2.0 g/10 minutes and equal to or less than 9.0 g/10 minutes, a silane coupling agent, and a hindered amine-based photostabilizer. pH of the hindered amine-based photostabilizer, which is measured by using a measuring method which will be described later is equal to or less than 9.0.

The present inventors recognized that the hindered amine-based photostabilizer of which the pH is equal to or less than 9.0 is combined with the ethylene·α-olefin copolymer of the low MFR type and the silane coupling agent, and thus longitudinal stability in adhesiveness of the obtained solar-cell encapsulating material is improved.

Regarding a mechanism which obtains such advantages, the present invention is not limited. However, the present inventors predict as follows. Firstly, when the pH of the hindered amine-based photostabilizer is more than the upper limit value under a condition that the hindered amine-based photostabilizer and the silane coupling agent coexist, hydrolysis of a substituted alkoxyl group of Si in the silane coupling agent proceeds, and then the hydrolyzed silane coupling agent is condensed. Thus, a condensate of the silane coupling agent in the solar-cell encapsulating material is generated. As a result, it is considered that an amount of the silane coupling agent which is effectively usable is reduced and the adhesiveness of the solar-cell encapsulating material is reduced.

On the contrary, when the pH of the hindered amine-based photostabilizer is equal to or less than the upper limit value, the hydrolysis and the condensation of the silane coupling agent are suppressed. As a result, it is considered that an amount of the silane coupling agent which is effectively usable can be maintained, and reduction in adhesiveness of the obtained solar-cell encapsulating material can be suppressed.

Accordingly, in spite of being an ethylene·α-olefin copolymer of the low MFR type, it is possible to improve preservation stability of the silane coupling agent provided in the resin composition, by using such a hindered amine photostabilizer. Thus, it is possible to prevent gradual reduction in adhesiveness of the solar-cell encapsulating material for a period from after the solar-cell encapsulating material is molded, until lamination is performed.

### <Ethylene·α-olefin Copolymer>

The resin composition for a solar-cell encapsulating material according to the embodiment includes an ethylene·α-olefin copolymer.

The ethylene·α-olefin copolymer is obtained by copolymerizing ethylene and α-olefin having 3 to 20 carbon atoms. As α-olefin, generally, α-olefin having 3 to 20 carbon atoms can be singly used, or be used in combination of two or more types. As α-olefin having 3 to 20 carbon atoms, straight-chained or branched α-olefin can be used. Examples of the straight-chained or branched α-olefin include propylene, 1-butene, 1-pentene, 1-hexene, 3-methyl-1-butene, 3,3-dimethyl-1-butene, 4-methyl-1-pentene, 1-octene, 1-decene, and 1-dodecene. Among these materials, α-olefin of which the number of carbon atoms is equal to or less than 10 is preferable, and α-olefin of which the number of carbon atoms is 3 to 8 is particularly preferable. From a viewpoint of easy acquisition, propylene, 1-butene, 1-pentene, 1-hexene, 4-methyl-1-pentene, and 1-octene are preferable. The ethylene·α-olefin copolymer may be a random copolymer or a block copolymer. However, from a viewpoint of flexibility, the random copolymer is preferable.

The ethylene·α-olefin copolymer may be a copolymer formed of ethylene, α-olefin having 3 to 20 carbon atoms, and non-conjugated polyene. α-olefin is similar to the above descriptions. Examples of non-conjugated polyene include 5-ethylidene-2-norbornene (ENB), 5-vinyl-2-norbornene (VNB), and dicyclopentadiene (DCPD). Such non-conjugated polyene may be singly used or be used in combination of two or more types.

An aromatic vinyl compound may be used together for the ethylene·α-olefin copolymer. Examples of such an aromatic vinyl compound include styrenes such as styrene, o-methyl styrene, m-methyl styrene, p-methyl styrene, o,p-dimethylstyrene, methoxystyrene, vinyl benzoate, methyl vinyl benzoate, vinylbenzyl acetate, hydroxystyrene, p-chlorostyrene, and divinylbenzene; and 3-phenylpropylene, 4-phenylpropylene, α-methyl styrene, and cyclic olefins having 3 to 20 carbon atoms. Examples of the cyclic olefins having 3 to 20 carbon atoms include cyclopentene, cycloheptene, norbornene, and 5-methyl-2-norbornene.

Regarding the ethylene·α-olefin copolymer, the upper limit value of the melt flow rate (MFR) of the ethylene·α-olefin copolymer, which is measured based on ASTM D1238, under conditions of 190°C and the load of 2.16 kg is equal to or more than 2.0 g/10 minutes and equal to or less than 9.0 g/10 minutes. The upper limit value of the MFR is equal to or less than 9.0 g/10 minutes, and preferably equal to or less than 8.0 g/10 minutes. The lower limit value of the MFR is equal to or more than 2.0 g/10 minutes.

The MFR of the ethylene·α-olefin copolymer may be adjusted by adjusting a polymerization temperature, polymerization pressure when a polymerization reaction which will be described later is performed, along with a molar ratio and the like of monomer concentration and hydrogen concentration of ethylene and α-olefin in a polymerization system.

When the MFR is in the above range, fluidity of the resin composition for a solar-cell encapsulating material is reduced, and thus it is possible to prevent mess of a laminating device by a molten resin protruded when the solar-cell encapsulating material is laminated on a cell element. From this point, it is preferable that the MFR is in the above range. In addition, it is possible to suppress occurrence of a case where the solar-cell encapsulating material is extruded when the colored solar-cell encapsulating material is laminated on the back surface of the cell element, the extruded solar-cell encapsulating material is wrapped around the front side of the solar cell, and thus the appearance of the solar cell becomes worse.

It is preferable that the ethylene·α-olefin copolymer satisfies at least one requirement among the following requirements a1) to a3), and it is particularly preferable that the ethylene·α-olefin copolymer satisfies all of the following requirements a1) to a3).

### (Requirement a1)

A content percentage of a constituent unit which is included in the ethylene·α-olefin copolymer and is derived from ethylene is preferably 80 to 90 mol%, more preferably 80 to 88 mol%, further preferably 82 to 88 mol%, and particularly preferably 82 to 87 mol%. A content percentage of a constituent unit (also described as "an α-olefin unit" below) which is included in the ethylene·α-olefin copolymer and is derived from α-olefin having 3 to 20 carbon atoms is preferably 10 to 20 mol%, more preferably 12 to 20 mol%, further preferably 12 to 18 mol%, and particularly preferably 13 to 18 mol%.

When the content percentage of the α-olefin unit included in the ethylene·α-olefin copolymer is equal to or more than the lower limit value, high transparency is obtained. Because appropriate flexibility is obtained, it is possible to prevent occurrence of cracks in a solar cell element, and generation of shards and the like of a thin film electrode when laminate molding is performed for a solar cell module.

When the content percentage of the α-olefin unit included in the ethylene·α-olefin copolymer is equal to or less than the upper limit value, the crystallization rate of the ethylene·α-olefin copolymer becomes appropriate. Thus, because the stickiness does not occur on the sheet, it is possible to prevent blocking and to improve feeding properties of the sheet. In addition, it is possible to suppress deterioration of thermal resistance of the solar-cell encapsulating material.

### (Requirement a2)

Density of the ethylene·α-olefin copolymer which is measured based on ASTM D1505 is preferably 0.865 to 0.884 g/cm³, more preferably 0.866 to 0.883 g/cm³, further preferably 0.866 to 0.880 g/cm³, and particularly preferably 0.867 to 0.880 g/cm³. The density of the ethylene·α-olefin copolymer can be adjusted based on balance between the content percentage of an ethylene unit and the content percentage of the α-olefin unit. That is, when the content percentage of the ethylene unit is increased, crystallinity is increased, and it is possible to obtain an ethylene·α-olefin copolymer having high density. When the content percentage of the ethylene unit is decreased, crystallinity is lowered, and it is possible to obtain an ethylene·α-olefin copolymer having low density.

When the density of the ethylene·α-olefin copolymer is equal to or less than the upper limit value, crystallinity becomes appropriate, and it is possible to improve transparency of the obtained solar-cell encapsulating material. Flexibility also becomes appropriate, and it is possible to prevent the occurrence of cracks in a cell being a solar cell element, and the generation of shards and the like of a thin film electrode when laminate molding is performed for a solar cell module.

When the density of the ethylene·α-olefin copolymer is equal to or more than the lower limit value, it is possible to increase the crystallization rate of the ethylene·α-olefin copolymer. Since occurring of the stickiness on the sheet is difficult, it is possible to suppress occurrence of blocking and to improve feeding properties of a sheet. Since cross-linking is sufficiently performed, it is possible to suppress deterioration of thermal resistance of the solar-cell encapsulating material.

### (Requirement a3)

Shore A hardness of the ethylene·α-olefin copolymer, which is measured based on ASTM D2240 is preferably 60 to 85, more preferably 62 to 83, further preferably 62 to 80, and particularly preferably 65 to 80. The Shore A hardness of the ethylene·α-olefin copolymer can be adjusted by controlling the content percentage of the ethylene unit or the density of the ethylene·α-olefin copolymer to be in the above-described corresponding numerical range. That is, the ethylene·α-olefin copolymer in which the content percentage of the ethylene unit is high and the density is high has high Shore A hardness . The ethylene·α-olefin copolymer in which the content percentage of the ethylene unit is low and the density is low has low Shore A hardness . The Shore A hardness is measured after a test sheet piece is applied a load, and then a period which is equal to or longer than 15 seconds elapses.

When the Shore A hardness is equal to or more than the lower limit value, occurring of stickiness of the ethylene·α-olefin copolymer can be difficult, and blocking can be suppressed. When the solar-cell encapsulating material is processed so as to have a sheet shape, it is possible to improve the feeding properties of a sheet, and to suppress deterioration of the thermal resistance of a solar-cell encapsulating material.

When the Shore A hardness is equal to or less than the upper limit value, it is possible to decrease crystallinity and to improve transparency of a solar-cell encapsulating material. Further, since flexibility is high, it is possible to prevent the occurrence of cracks in a cell being a solar cell element, and the generation of shards and the like of a thin film electrode when laminate molding is performed for the solar cell module.

When the entirety of a resin component included in the resin composition for a solar-cell encapsulating material is defined to be 100 mass%, the content of the ethylene·α-olefin copolymer is preferably equal to or more than 80 mass%, more preferably equal to or more than 90 mass%, further preferably equal to or more than 95 mass%. The content of the ethylene·α-olefin copolymer is preferably 100 mass%. Thus, it is possible to obtain a solar-cell encapsulating material which is excellent in balance between characteristics such as transparency, adhesiveness, thermal resistance, flexibility, cross-linking characteristics, electrical characteristics, and the like.

### (Manufacturing Method of Ethylene·α-Olefin Copolymer)

An ethylene·α-olefin copolymer can be manufactured by using the following various metallocene compounds as a catalyst. As the metallocene compound, for example, metallocene compounds disclosed in Japanese Laid-open Patent Publication No. 2006-077261, Japanese Laid-open Patent Publication No. 2008-231265, Japanese Laid-open Patent Publication No. 2005-314680, and the like. As the metallocene compound, a metallocene compound having a structure different from those of the metallocene compound disclosed in these Patent Documents may be used. A combination of two or more types of metallocene compounds may be used.

The ethylene·α-olefin copolymer may be polymerized by using any of vapor phase polymerization, and liquid phase polymerization such as slurry polymerization and solution polymerization, which have been conventionally known well. Preferably, the ethylene·α-olefin copolymer is polymerized by using liquid phase polymerization such as solution polymerization.

### <Silane Coupling Agent>

The resin composition for a solar-cell encapsulating material according to the embodiment includes the silane coupling agent. Including the silane coupling agent allows adhesion strength between the obtained solar-cell encapsulating material and other members to be excellent.

As the silane coupling agent, a silicon compound having an alkoxy group is preferable. Examples of such a silicon compound include vinyltriethoxysilane, vinyltrimethoxysilane, vinyl tris(β-methoxyethoxy silane), 3-methacryloxypropyl trimethoxy silane, 3-methacryloxypropyl methyl dimethoxy silane, 3-methacryloxypropyl triethoxy silane, 3-methacryloxypropyl methyl diethoxy silane, and 3-acryloxypropyl trimethoxy silane. Among these materials, 3-methacryloxypropyl trimethoxy silane and 3-acryloxypropyl trimethoxy silane are preferable.

The content of silane coupling agent in the resin composition for a solar-cell encapsulating material is preferably equal to or more than 0.01 parts by mass and equal to or less than 5 parts by mass, with respect to 100 parts by mass of the ethylene·α-olefin copolymer. The content of silane coupling agent is more preferably equal to or more than 0.1 parts by mass and equal to or less than 4 parts by mass, further preferably equal to or more than 0.1 parts by mass and equal to or less than 2 parts by mass, furthermore preferably equal to or more than 0.1 parts by mass and equal to or less than 1 part by mass, and particularly preferably equal to or more than 0.1 parts by mass and equal to or less than 0.5 parts by mass.

When the content of the silane coupling agent is equal to or more than the lower limit value, it is possible to more improve the adhesion strength between the solar-cell encapsulating material and other members.

When the content of the silane coupling agent is equal to or less than the upper limit value, it is possible to suppress an increase of an added amount of organic peroxide used for performing a grafting reaction of the silane coupling agent with the ethylene·α-olefin copolymer when lamination of a solar cell module is performed. It is possible to suppress condensation between silane coupling agents, and to improve the adhesion strength.

### <Hindered Amine-Based Photostabilizer>

The resin composition for a solar-cell encapsulating material according to the embodiment includes a hindered amine-based photostabilizer indicated by the formulae (1) to (4).

pH of the hindered amine-based photostabilizer measured by using the following measuring method is equal to or less than 9.0. The pH of the hindered amine-based photostabilizer is preferably equal to or less than 8.8, and particularly preferably equal to or less than 8.7.

The lower limit of the pH is not particularly limited. For example, the lower limit of the pH is equal to or more than 8.0, and is preferably equal to or more than 8.1.

### (Measuring Method)

A solution which contains 10 g of acetone, 1 g of water, and 0.01 g of the hindered amine-based photostabilizer is used as a sample, so as to measure the pH by using a potential difference measuring device.

For the hindered amine-based photostabilizer of which the pH is equal to or less than 9.0, a structure in which a 2,2,6,6-tetra-methyl-4-piperidyl skeleton is provided, and nitrogen is substituted with an alkyl group or an alkoxy group is preferable. Examples of the hindered amine-based photostabilizer of which the pH is equal to or less than 9.0 include bis(1,2,2,6,6-pentamethyl-4-piperidyl)sebacate (compound indicated by the following Formula (1)), methacrylic acid 1,2,2,6,6-pentamethyl-4-piperidyl (compound indicated by the following Formula (2)), decane diacid bis(2,2,6,6-tetramethyl-1-(octyloxy)-4-piperidinyl)ester (compound indicated by the following Formula (3)), 1,6-hexanediamine,N,N'-bis(1,2,2,6,6-pentamethyl-4-piperidyl)-,p olymer with morpholine-2,4,6-trichloro-1,3,5-triazine (compound indicated by the following Formula (4))

Among these materials, one type, or two or more types which are selected from a group consisting of the compounds indicated by the following Formulae (1) to (4) are included. It is preferable that the compounds of at least one of the following Formulae (1) and (2) are included. It is particularly preferable that the compound of the following Formula (1) is included. As the hindered amine-based photostabilizer of which the pH is equal to or less than 9.0, a commercial product may be used.

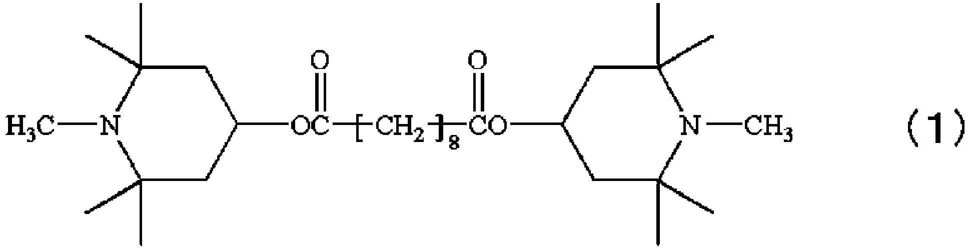

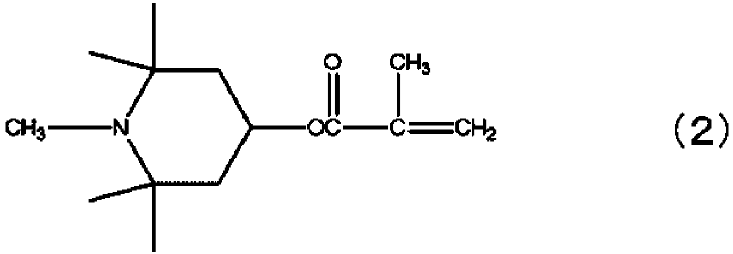

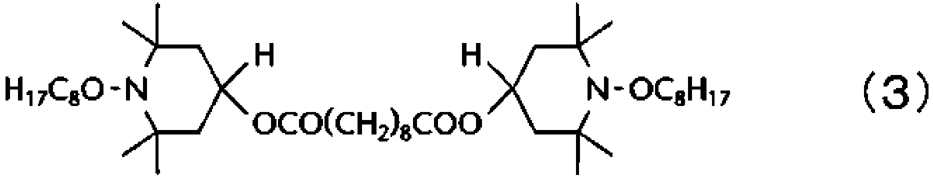

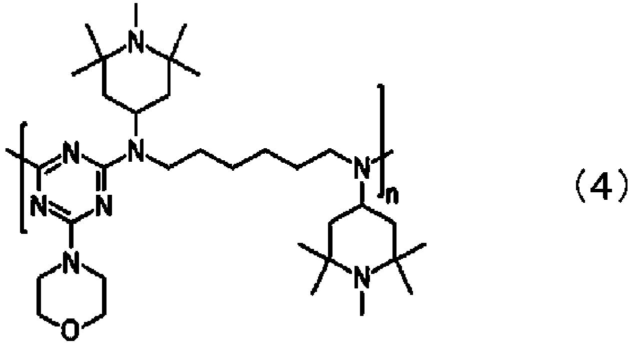

Here, n in Formula (4) is preferably an integer which is equal to or more than 2 and equal to or less than 10, and more preferably an integer which is equal to or more than 2 and equal to or less than 5.

Here, pH values of the compounds indicated by the above Formulae (1) to (4) are measured by using the above measuring method, and as a result, the pH values are as follows.
Formula (1): pH=8.7
Formula (2): pH=8.3
Formula (3): pH=8.1
Formula (4): pH=8.7

A hindered amine-based photostabilizer of which the pH is more than 9.0 may be used together within a range without impairing the advantages of the present invention. The hindered amine-based photostabilizer of which the pH is more than 9.0 may be used in a range in which the content of the hindered amine-based photostabilizer is preferably equal to or less than 90 mass%, more preferably equal to or less than 85 mass%, further preferably equal to or less than 70 mass%, furthermore preferably equal to or less than 50 mass%, and particularly preferably equal to or less than 20 mass%, with respect to 100 mass% of the entirety of the hindered amine-based photostabilizer included in the resin composition for a solar-cell encapsulating material.

The content of the hindered amine-based photostabilizer of which the pH is equal to or less than 9.0 is preferably equal to or more than 10 mass%, more preferably equal to or more than 15 mass%, further preferably equal to or more than 30 mass%, furthermore preferably equal to or more than 50 mass%, particularly preferably equal to or more than 80 mass%, and most preferably 100 mass%, with respect to 100 mass% of the entirety of the hindered amine-based photostabilizer included in the resin composition for a solar-cell encapsulating material.

The content of the hindered amine-based photostabilizer of which the pH is equal to or less than 9.0 in the resin composition for a solar-cell encapsulating material is preferably equal to or more than 0.01 parts by mass and equal to or less than 1 part by mass, with respect to 100 parts by mass of the ethylene·α-olefin copolymer. The content of the hindered amine-based photostabilizer of which the pH is equal to or less than 9.0 is more preferably equal to or more than 0.02 parts by mass and equal to or less than 0.8 parts by mass, further preferably equal to or more than 0.05 parts by mass and equal to or less than 0.5 parts by mass, and particularly preferably equal to or more than 0.05 parts by mass and equal to or less than 0.3 parts by mass.

When the content of the hindered amine-based photostabilizer is equal to or more than the lower limit value, it is possible to improve balance between weather resistance and thermal resistance of the obtained solar-cell encapsulating material. When the content of the hindered amine-based photostabilizer is equal to or less than the upper limit value, it is possible to suppress reduction of radicals generated by organic peroxide, and to improve the balance between the adhesiveness, the thermal resistance, and the cross-linking characteristics of the obtained solar-cell encapsulating material.

### <Other Additives>

The resin composition for a solar-cell encapsulating material according to the embodiment may appropriately include various components in a range without imparing the object of the present invention, in addition to the ethylene·α-olefin copolymer, the silane coupling agent, and the hindered amine-based photostabilizer which are described above.

For example, additives of one type, or two or more types which can be selected from the followings may be appropriately included: a cross-linking agent (organic peroxide) ; a cross-linking assistant; an ultraviolet absorbing agent; an oxidant inhibitor; a plasticizer; a filler; a pigment; a dye; an antistatic agent; an antibacterial agent; an antifungal agent; a flame retardant; a dispersant; and the like.

### (Organic Peroxide)

The resin composition for a solar-cell encapsulating material according to the embodiment may include a cross-linking agent (organic peroxide). Organic peroxide is included in the resin composition for a solar-cell encapsulating material, and thus it is possible to graft the silane coupling agent in the ethylene·α-olefin copolymer, and to perform cross-linking of the ethylene·α-olefin copolymer. Thus, the thermal resistance and the weather resistance of the obtained solar-cell encapsulating material are more improved.

Considering productivity of a solar cell module, the organic peroxide preferably has a half-life period which is equal to or shorter than 10 hours, and has a decomposition temperature which is equal to or lower than 105°C. From a viewpoint of safety, it is preferable that the highest preservation temperature is equal to or higher than 10°C.

From a viewpoint of balance between productivity when a sheet is molded by extrusion molding, calendered molding, and the like, and a cross-linking rate when laminate molding is performed for a solar cell module, the one minute half-life temperature of the organic peroxide is preferably equal to or higher than 100°C and equal to or lower than 170°C. When the one minute half-life temperature of organic peroxide is equal to or higher than 100°C, it is possible to easily perform sheet molding and to cause the appearance of a solar-cell encapsulating material sheet to become better. It is possible to prevent lowering of a dielectric breakdown voltage, to prevent deterioration of moisture permeability, and to improve adhesiveness of the obtained solar-cell encapsulating material sheet. When the one minute half-life temperature of the organic peroxide is equal to or lower than 170°C, it is possible to suppress a decrease of the cross-linking rate when the laminate molding is performed for a solar cell module, and to prevent deterioration of productivity of the solar cell module. In addition, it is possible to prevent deterioration of the thermal resistance and the adhesiveness of a solar-cell encapsulating material sheet.

Examples of the organic peroxide include dilauroyl peroxide, 1,1,3,3-tetramethylbutyl peroxy-2-ethylhexanoate, dibenzoyl peroxide, cyclohexanone peroxide, di-t-butyl perphthalate, cumene hydroperoxide, t-butyl hydroperoxide, 2,5-dimethyl-2,5-di(t-butylperoxy)hexene, 2,5-dimethyl-2,5-di(t-butylperoxy)hexane, t-amyl peroxy-2-ethylhexanoate, t-butyl peroxy-2-ethylhexanoate, t-butyl peroxy isobutyrate, t-butylperoxy maleate, 1,1-di(t-amyl peroxy)-3,3,5-trimethylcyclohexane, 1,1-di(t-amyl peroxy) cyclohexane, t-amyl peroxy isononanoate, t-amyl peroxy normal octoate, 1,1-di(t-butylperoxy)-3,3,5-trimethylcyclohexane, 1,1-di(t-butylperoxy)cyclohexane, t-butyl peroxy isopropyl carbonate, t-butyl peroxy-2-ethylhexyl carbonate, 2, 5-dimethyl-2, 5-di (benzoyl peroxy) hexane, t-amyl-peroxy benzoate, t-butyl peroxy acetate, t-butylperoxy isononanoate, t-butyl peroxybenzoate, 2,2-di(butylperoxy)butane, n-butyl-4,4-di(t-butylperoxy)butyrate, methyl ethyl ketone peroxide, ethyl-3,3-di(t-butylperoxy)butyrate, dicumyl peroxide, t-butyl cumyl peroxide, t-butyl peroxybenzoate, di-t-butyl peroxide, 1,1,3,3-tetramethyl butyl hydroperoxide, and acetylacetone peroxide. The organic peroxide may be singly used or be used in combination of two or more types.

Among these materials, 2,5-dimethyl-2,5-di(t-butylperoxy)hexene, 2,5-dimethyl-2,5-di(t-butylperoxy)hexane, t-butyl peroxy-2-ethylhexyl carbonate, and t-butyl peroxybenzoate are preferable.

The content of the organic peroxide in the resin composition for a solar-cell encapsulating material is preferably equal to or more than 0.1 parts by mass and equal to or less than 3 parts by mass, and more preferably equal to or more than 0.2 parts by mass and equal to or less than 2 parts by mass, with respect to 100 parts by mass of the ethylene·α-olefin copolymer.

### (Cross-Linking Assistant)

The resin composition for a solar-cell encapsulating material according to the embodiment may include a cross-linking assistant.

Examples of the cross-linking assistant include an allyl group-containing compound such as triallyl isocyanurate, and trimethallyl isocyanurate; and multi-functional acrylate.

The content of the cross-linking assistant in the resin composition for a solar-cell encapsulating material is preferably equal to or less than 10 parts by mass, and more preferably equal to or more than 0.15 parts by mass and equal to or less than 5 parts by mass, with respect to 100 parts by mass of the ethylene·α-olefin copolymer. Thus, a solar-cell encapsulating material having an appropriate cross-linked structure is obtained, and it is possible to more improve the thermal resistance, the mechanical characteristics, and the adhesiveness of a solar-cell encapsulating material.

### (Ultraviolet Absorbing Agent)

The resin composition for a solar-cell encapsulating material according to the embodiment may include an ultraviolet absorbing agent.

Examples of the ultraviolet absorbing agent include a benzophenone-based ultraviolet absorbing agent such as 2-hydroxy-4-methoxybenzophenone, 2,2-dihydroxy-4-methoxybenzophenone, 2-hydroxy-4-methoxy-2-carboxy benzophenone, and 2-hydroxy-4-normal-octyloxy benzophenone; a benzotriazole-based ultraviolet absorbing agent such as 2-(2-hydroxy-3,5-di-tert-butylphenyl)benzotriazole, 2-(2-hydroxy-5-methylphenyl)benzotriazole, and 2-(2-hydroxy-5-tert-octylphenyl)benzotriazole; and a salicylic acid ester-based ultraviolet absorbing agent such as phenyl salicylate, and p-octyl phenyl salicylate.

The content of the ultraviolet absorbing agent in the resin composition for a solar-cell encapsulating material is, for example, equal to or more than 0.005 parts by mass and equal to or less than 3 parts by mass, with respect to 100 parts by mass of the ethylene·α-olefin copolymer.

### (Oxidant Inhibitor)

The resin composition for a solar-cell encapsulating material according to the embodiment may include an oxidant inhibitor.

Examples of the oxidant inhibitor include a hindered phenol-based oxidant inhibitor and a phosphite-based oxidant inhibitor.

The content of the oxidant inhibitor in the resin composition for a solar-cell encapsulating material is, for example, equal to or more than 0.005 parts by mass and equal to or less than 1 part by mass, with respect to 100 parts by mass of the ethylene·α-olefin copolymer.

### [Solar-Cell Encapsulating Material]

When the solar-cell encapsulating material according to the embodiment includes the resin composition for a solar-cell encapsulating material, the configuration of the solar-cell encapsulating material is not particularly limited. However, the entire shape of the solar-cell encapsulating material is preferably sheet-like. Even when the solar-cell encapsulating material according to the embodiment is formed of only a sheet which is formed of the resin composition for a solar-cell encapsulating material, the solar-cell encapsulating material may be a stacked body formed of two layers or more which are a layer formed of the resin composition for a solar-cell encapsulating material, and another layer. However, only a sheet formed of the resin composition for a solar-cell encapsulating material according to the embodiment is preferable.

The thickness of the solar-cell encapsulating material sheet is not particularly limited, but is generally about 0.2 to 1.2 mm. When the thickness is in this range, it is possible to suppress occurrence of damage of the front surface-side transparent protection member, the solar cell element, a thin-film electrode, and the like in the laminate process, and to obtain high photovoltaic amount by ensuring sufficient light transmittance. In addition, it is preferable that laminate molding can be performed for a solar cell module at a low temperature.

Regarding the solar-cell encapsulating material according to the embodiment, it is preferable that the specific volume resistivity which is measured at a temperature of 60°C, and an applied voltage of 1000 V based on JIS K6911 is equal to or more than 1.0X10¹⁶ Ω·cm. When the specific volume resistivity of the solar-cell encapsulating material is equal to or more than 1.0X10¹⁶ Ω·cm, it is possible to suppress deterioration in a voltage applied state which may be referred to as PID. In order to cause the specific volume resistivity to be in the above range, a compound indicated by Formula (2), Formula (3), or Formula (4) is preferably used as the hindered amine-based photostabilizer.

After a solar-cell encapsulating material sheet is heated and pressed at 150°C and 250 Pa for 3 minutes, and then is heated and pressed at 150°C and 100 kPa for 10 minutes, the specific volume resistivity is measured. The sheet in a module stacked body is measured after other layers are removed.

The upper limit of the specific volume resistivity is not particularly limited, but is equal to or less than 1.0X10¹⁸ Ω·cm, for example. When the specific volume resistivity is more than 1.0X10¹⁸ Ω·cm, static electricity is charged to the sheet, and thus dust is easily attracted. The dust is inserted into a solar cell module, and thus power generation efficiency or long-term reliability may be degraded.

### <Manufacturing Method of Solar-Cell Encapsulating Material Sheet>

The manufacturing method of the solar-cell encapsulating material sheet according to the embodiment is not particularly limited. However, for example, the following method is exemplified. Firstly, an ethylene·α-olefin copolymer, a silane coupling agent, a hindered amine-based photostabilizer, if necessary, an organic peroxide or other additives are dry-blended. Then, a mixture obtained by the blending is supplied to an extruder from a hopper, and, if necessary, the mixture is molten-kneaded at a temperature lower than the one hour half-life period temperature of organic peroxide. Then, extrusion molding is performed from the tip end of the extruder, so as to have a sheet shape, thereby a solar-cell encapsulating material sheet is manufactured. The molding may be performed by using a well-known method of using a T-die extruder, a calendar molding machine, an inflation molding machine, and the like.

The solar-cell encapsulating material sheet which does not include organic peroxide may be manufactured by using the above method, and organic peroxide may be added to the manufactured sheet by using an impregnation method. In a case where two or more types of organic peroxide are included, molten kneading may be performed at a temperature which is lower than the lowest one hour half-life period temperature of organic peroxide.

### [Solar Cell Module]

The solar-cell encapsulating material according to the embodiment is used for encapsulating a solar cell element in a solar cell module.

As a configuration of the solar cell module, for example, a configuration in which a front surface-side transparent protection member, a light-receiving surface-side solar-cell encapsulating material sheet, a solar cell element, a back surface-side solar-cell encapsulating material sheet, and a back surface-side protection member (back sheet) are stacked in this order is exemplified. However, the configuration of the solar cell module is not particularly limited.

The solar-cell encapsulating material according to the embodiment is used in either or both of the light-receiving surface-side solar-cell encapsulating material sheet and the back surface-side solar-cell encapsulating material sheet. A layer such as the light-receiving surface-side solar-cell encapsulating material sheet or the back surface-side solar-cell encapsulating material sheet, which is formed by performing cross-linking of the solar-cell encapsulating material, is also referred to as an encapsulating layer.

FIG. 1 illustrates an example of a sectional view of a solar cell module according to the embodiment.

A solar cell module 10 includes a plurality of solar cell elements 13, a pair of a light-receiving surface-side solar-cell encapsulating material sheet 11 and a back surface-side solar-cell encapsulating material sheet 12, a front surface-side transparent protection member 14, and a back surface-side protection member (back sheet) 15. The pair of a light-receiving surface-side solar-cell encapsulating material sheet 11 and a back surface-side solar-cell encapsulating material sheet 12 is used for interposing and encapsulating the solar cell element 13.

### (Solar Cell Element)

As the solar cell element 13, various solar cell elements may be used. The various solar cell elements may be formed of silicons such as single-crystalline silicon, polycrystalline silicon, and amorphous silicon, semiconductors of III-V group compounds or II-VI group compounds such as gallium-arsenic, copper-indium-selenium, and cadmium-tellurium.

In the solar cell module 10, the plurality of solar cell elements 13 are electrically connected to each other in series through an interconnector 16. The interconnector 16 includes a conductive line and a solder joint portion.

### (Front Surface-Side Transparent Protection member)

Examples of the front surface-side transparent protection member 14 include a glass plate; and a resin plate formed by an acrylic resin, polycarbonate, polyester, and a fluorine-containing resin.

The solar-cell encapsulating material sheet according to the embodiment has good adhesiveness to the front surface-side transparent protection member 14.

### (Back Surface-Side Protection member)

As the back surface-side protection member (back sheet) 15, a single body or a multilayer sheet of metal or various thermoplastic resin films and the like is exemplified. For example, metal such as tin, aluminum, and stainless steel; an inorganic material such as glass; the various thermoplastic resin films formed of polyester, inorganic vapor deposition polyester, a fluorine-containing resin, and polyolefin; and the like are exemplified.

The back surface-side protection member 15 may be a single layer or a multilayer.

The solar-cell encapsulating material sheet according to the embodiment has good adhesiveness to the back surface-side protection member 15.

### <Manufacturing Method of Solar Cell Module>

The manufacturing method of the solar cell module according to the embodiment is not particularly limited. However, for example, the following method is exemplified.

Firstly, the plurality of solar cell elements 13 which are electrically connected to each other by using the interconnector 16 are interposed between the pair of the light-receiving surface-side solar-cell encapsulating material sheet 11 and the back surface-side solar-cell encapsulating material sheet 12. The light-receiving surface-side solar-cell encapsulating material sheet 11 and the back surface-side solar-cell encapsulating material sheet 12 are interposed between the front surface-side transparent protection member 14 and the back surface-side protection member 15, and thereby a stacked body is manufactured. Then, the stacked body is heated, and thus the light-receiving surface-side solar-cell encapsulating material sheet 11 and the back surface-side solar-cell encapsulating material sheet 12 are adhered to each other, the light-receiving surface-side solar-cell encapsulating material sheet 11 and the front surface-side transparent protection member 14 are adhered to each other, and the back surface-side solar-cell encapsulating material sheet 12 and the back surface-side protection member 15 are adhered to each other.

Regarding manufacturing of the solar cell module, heating may be performed by using a conventional similar laminating method in which a sheet formed of the solar-cell encapsulating material is previously produced, and press bonding is performed on the sheet at a temperature at which the encapsulating material is molten. For example, heating may be performed at a lamination temperature of 145°C to 170°C, and vacuum pressure which is equal to or less than 10 Torr, in vacuum for 0.5 to 10 minutes. Then, pressing by atmospheric pressure may be performed for 2 to 30 minutes, and thereby a module having the above-described configuration may be formed. In this case, the solar-cell encapsulating material includes specific type of organic peroxide, and thus has excellent cross-linking characteristics. Thus, it is not necessary that a two-stage bonding process is performed when the module is formed, and it is possible to finish the process at a high temperature for a short time. It is possible to remarkably enhance productivity of the module. The two-stage bonding process may be performed by using an oven. In a case where the two-stage bonding process is performed, for example, heating may be performed in a range of 120°C to 170°C for 1 to 120 minutes, thereby a module may be also produced.

Hitherto, the embodiment according to the present invention is described with reference to the drawings. However, the above-described embodiment is only an example of the present invention, and various configurations other than the above embodiment may be employed.

### [Example]

The present invention will be specifically described below based on examples.

### (1) Measuring Method

### [Content Percentages of Ethylene Unit and α-Olefin Unit]

0.35 g of a sample were heated and dissolved in 2.0 ml of hexachlorobutadiene, and thereby a solution was obtained. The obtained solution is filtered by a glass filter (G2). Then, 0.5 ml of deuterated benzene was added to the resultant of filtering. The resultant of addition was put into a NMR tube having an inner diameter of 10 mm. ¹³C-NMR was performed at 120°C by using JNM GX-400 type NMR measuring device (manufactured by Jeol Ltd.). The accumulated number of times of measuring was equal to or greater than 8000 times. The content percentage of the ethylene unit and the content percentage of the α-olefin unit in a copolymer were determined by using the obtained ¹³C-NMR spectrum.

### [MFR]

The MFR of the ethylene·α-olefin copolymer was measured under conditions of a temperature of 190°C, and the load of 2.16 kg, based on ASTM D1238.

### [Density]

The density of the ethylene·α-olefin copolymer was measured based on ASTM D1505.

### [Shore A Hardness]

After the ethylene·α-olefin copolymer was heated at 190°C for 4 minutes, and was pressed at 10 MPa, the ethylene·α-olefin copolymer was pressed at 10 MPa and cooled up to a normal temperature for 5 minutes, thereby a sheet having a thickness of 3 mm was obtained. The Shore A hardness of the ethylene·α-olefin copolymer was measured based on ASTM D2240 by using the obtained sheet.

### (2) Synthesis of Ethylene·α-Olefin Copolymer

### (Synthesis Example 1)

A toluene solution of methylaluminoxane as a cocatalyst was supplied to one supply port of a continuous polymerization reactor which included a stirring blade and has an inner volume of 50 L, at a rate of 8 mmol/hr. A hexane slurry of bis(1,3-dimethyl-cyclopentadienyl)zirconium dichloride as a main catalyst was supplied to the one supply port at a rate of 0.025 mmol/hr. A hexane solution of triisobutyl aluminum was supplied to the one supply port at a rate of 0.6 mmol/hr. Normal hexane which had been dehydrated and refined was continuously supplied so as to cause the total amount of a catalyst solution and a polymerization solvent to be 20 L/hr. At the same time, ethylene was continuously supplied to the other supply port of the polymerization reactor at a rate of 3 kg/hr, 1-butene was continuously supplied to the other supply port at a rate of 15 kg/hr, and hydrogen was continuously supplied to the other supply port at a rate of 1.5 NL/hr. Continuous solution polymerization was performed under conditions of a polymerization temperature of 90°C, the entire pressure of 3 MPaG, and residence time of 1.0 hour.

A normal hexane/toluene mixed solution of an ethylene·α-olefin copolymer, which was generated in the polymerization reactor was continuously discharged through an exhaust port provided at the bottom portion of the polymerization reactor. The normal hexane/toluene mixed solution of the ethylene·α-olefin copolymer was guided to a linking pipe of which a jacket portion was heated with steam of 3 to 25 kg/cm² such that the normal hexane/toluene mixed solution of the ethylene·α-olefin copolymer was in a range of 150°C to 190°C. A supply port into which methanol functioning as a catalyst inactivator is injected was attached to just before the linking pipe. A methanol was injected at a rate of about 0.75 L/hr, and the injected methanol was joined to the normal hexane/toluene mixed solution of the ethylene·α-olefin copolymer.

The normal hexane/toluene mixed solution of the ethylene·α-olefin copolymer, which was held at about 190°C in a linking pipe having a steam jacket was continuously delivered to a flash tank, so as to hold about 4.3 MPaG. The delivery was performed by adjusting an opening of a pressure control valve which was provided at a termination portion of the linking pipe. In transfer into the flash tank, the temperature of the solution and the opening of a pressure regulating valve were set so as to hold pressure in the flash tank to be about 0.1 MPaG, and to hold the temperature of a steam portion in the flash tank to be about 180°C. Then, strands were cooled in a water tank through a single-axis extruder in which the temperature of a dice was set to be 180°C. The strands were cut out by a pellet cutter, and thereby an ethylene·α-olefin copolymer was obtained as a pellet.

Table 1 shows physical properties of the obtained ethylene·α-olefin copolymer.

### (Synthesis Examples 2 to 6)

Various supplied amount and the like were adjusted based on the polymerization conditions of Synthesis Example 1, and thus an ethylene·α-olefin copolymer was obtained.

Table 1 shows physical properties of the obtained ethylene·α-olefin copolymer.

### (Synthesis Example 7)

Processes were performed similarly to Synthesis Example 1, so as to obtain an ethylene·α-olefin copolymer, except for the following points: a point that a hexane solution of bis(p-tolyl)methylene

### (cyclopentadienyl)

(1,1,4,4,7,7,10,10-octamethyl-1,2,3,4,7,8,9,10-octahydro dibenz (b,h)-fluorenyl)zirconium dichloride as the main catalyst was supplied at a rate of 0.003 mmol/hr, and a toluene solution of methylaluminoxane as the cocatalyst was supplied at a rate of 3.0 mmol/hr; a point that ethylene was supplied at a rate of 4.3 kg/hr; a point that 1-octene was supplied at a rate of 6.4 kg/hr instead of 1-butene; a point that normal hexane which had been dehydrated and refined was continuously supplied so as to cause the total amount of 1-octene, the catalyst solution, and normal hexane which was used as a polymerization solvent, and was dehydrated and refined, to be 20 L/hr; a point that hydrogen was supplied at a rate of 10 NL/hr; and a point that the polymerization temperature was set to be 130°C.

Table 1 shows physical properties of the obtained ethylene·α-olefin copolymer.

**[Table 1]**

| | Synthesis Example 1 | Synthesis Example 2 | Synthesis Example 3 | Synthesis Example 4 | Synthesis Example 5 | Synthesis Example 6 | Synthesis Example 7 |
|---|---|---|---|---|---|---|---|
| Type of α-olefin | 1-butene | 1-butene | 1-butene | 1-butene | 1-butene | 1-butene | 1-octene |
| Content percentage of α-olefin unit [mol%] | 14 | 18 | 13 | 17 | 11 | 21 | 11 |
| Content percentage of ethylene unit [mol%] | 86 | 82 | 87 | 83 | 89 | 79 | 89 |
| Density [g/cm³] | 0.870 | 0.865 | 0.873 | 0.866 | 0.884 | 0.863 | 0.884 |
| MFR [g/10 minutes] | 4.0 | 9.5 | 7.1 | 0.3 | 14 | 21 | 2.1 |
| Shore A hardness [-] | 70 | 60 | 73 | 62 | 84 | 56 | 84 |

### [Example 1]

### <Manufacturing of Solar-Cell Encapsulating Material Sheet>

With respect to 100 parts by mass of the ethylene·α-olefin copolymer obtained in Synthesis Example 1, 0.7 parts by mass of t-butyl peroxy-2-ethylhexyl carbonate as a cross-linking agent, 1.2 parts by mass of triallyl isocyanurate as a cross-linking assistant, 0.4 parts by mass of 3-methacryloxypropyl trimethoxy silane as a silane coupling agent, 0.2 parts by mass of a compound (pH 8.7, bis(1,2,2,6,6-pentamethyl-4-piperidyl)sebacate) which was indicated by Formula (1) and was used as a hindered amine-based photostabilizer, 0.4 parts by mass of 2-hydroxy-4-normal-octyloxybenzophenone as an ultraviolet absorbing agent, 0.1 parts by mass of octadecyl-3-(3,5-di-tert-butyl-4-hydroxyphenyl)propionate as an oxidant inhibitor 1, and 0.1 parts by mass of tris(2,4-di-tert-butyl phenyl) phosphite as an oxidant inhibitor 2 were mixed with each other.

The composition was inserted into LABO PLASTOMILL (manufactured by Toyo Seiki Seisaku-sho Ltd.), and was kneaded at 100°C, and the number of revolutions of 30 rpm for 5 minutes. Then, pressing was performed at 100°C and 0 MPa for 3 minutes, and was performed at 100°C and 10 MPa for 2 minutes. Pressing was performed at 10 MPa for 3 minutes in a cooling press, thereby a sheet of 0.5 mm was obtained.

Regarding the solar-cell encapsulating material sheet obtained in this manner, the next preservation stability test was performed, and specific volume resistivity was evaluated.

Table 2 shows the obtained evaluation results.

### <Preservation Stability Test>

The obtained solar-cell encapsulating material sheet had been stored under conditions of 40°C and 90%RH for two months. Adhesion strength at an initial time and adhesion strength after storage for two months were measured by the following method. Evaluation was performed using retention of the adhesion strength after storage for two months to the adhesion strength at the initial time.
Evaluation "A": retention of the adhesion strength after storage for two months is equal to or more than 90%
Evaluation "B": retention of the adhesion strength after storage for two months is equal to or more than 70% and less than 90%
Evaluation "C": retention of the adhesion strength after storage for two months is less than 70%

### (Adhesion Strength)

The manufactured solar-cell encapsulating material sheet was stacked on glass, and was placed on a hot plate of which the temperature is adjusted to be 150°C in a vacuum laminator. Vacuum decompression was performed for 3 minutes, and then heating was performed for 10 minutes. Thus, a stacked body of the glass and the solar-cell encapsulating material sheet was manufactured. The solar-cell encapsulating material sheet provided on this stacked body was cut out by the width of 10 mm, and peeling strength of the glass which is an adhering object was measured by 180 degrees peel. The peeling strength by 180 degrees peel was measured at 23°C and a tensioning rate of 300 mm/minute by using a tension tester (manufactured by Shimadzu Corporation). An average value in measurement of three times was employed, and was used as "the adhesion strength".

### <Specific Volume Resistivity>

After a sheet sample formed of the solar-cell encapsulating material was cut so as to have a size of 10 cmX10 cm, heating and decompressing was performed at 150°C and 250 Pa by using a laminating device (manufactured by NPC Corporation, LM-110X160S) for 3 minutes. Then, heating and pressing was performed at 150°C and 100 kPa for 10 minutes, and thus a cross-linked sheet for measurement was manufactured. The specific volume resistivity (Ω·cm) of the manufactured cross-linked sheet was measured at an applied voltage of 1000 V based on JIS K6911. When measurement was performed, a temperature was set to be 60±2°C by using a high-temperature measurement chamber "12708" (manufactured by Advanced Corporation), and a micro-ammeter "R8340A" (manufactured by Advanced Corporation) was used.

### [Examples 2 to 7, Comparative Examples 1 and 2, and Reference Examples 1 and 2]

Processes were performed similarly to Example 1 except for using a combination indicated by Table 2, and thus a solar-cell encapsulating material sheet is manufactured. The evaluation was performed.

Table 2 shows the obtained evaluation results.

**[Table 2]**

| | Example 1 | Example 2* | Example 3 | Example 4* | Example 5 | Example 6 | Example 7 | Comparative Example 1 | Comparative Example 2 | Reference Example 1 | Reference Example 2 |
|---|---|---|---|---|---|---|---|---|---|---|---|
| combination (part by mass) | | | | | | | | | | | |
| ethylene·α-olefin copolymer | | | | | | | | | | | |
| Synthesis Example 1 | 100 | | | | | | 100 | 100 | | | |
| Synthesis Example 2 | | 100 | | | | | | | 100 | | |
| Synthesis Example 3 | | | 100 | | 100 | | | | | | |
| Synthesis Example 4 | | | | 100 | | | | | | | |
| Synthesis Example 5 | | | | | | | | | | 100 | |
| Synthesis Example 6 | | | | | | | | | | | 100 |
| Synthesis Example 7 | | | | | | 100 | | | | | |
| Silane coupling agent | 0.4 | 0.4 | 0.4 | 0.4 | 0.3 | 0.4 | 0.4 | 0.4 | 0.4 | 0.4 | 0.4 |
| Cross-linking agent | 0.7 | 0.8 | 0.8 | 0.6 | 0.8 | 0.6 | 0.6 | 0.6 | 0.6 | 0.6 | 0.6 |
| Cross-linking assistant | 1.2 | 1.2 | 1.2 | 1.2 | 1.2 | 1.2 | 1.2 | 1.2 | 1.2 | 1.2 | 1.2 |
| Ultraviolet absorbing agent | 0.4 | 0.4 | | 0.4 | 0.4 | 0.4 | | 0.4 | 0.4 | 0.4 | 0.4 |
| Hindered amine-based photostabilizer 1 | 0.2 | | | | | | | | | | 0.2 |
| Hindered amine-based photostabilizer 2 | | | 0.2 | | 0. 03 | | | | | | |
| Hindered amine-based photostabilizer 3 | | 0. 05 | | | | 0. 05 | | | | | |
| Hindered amine-based photostabilizer 4 | | | | 0.1 | | | 0. 03 | | | | |
| Hindered amine-based photostabilizer 5 | | 0.05 | | 0. 05 | 0. 07 | | 0.12 | 0.2 | | 0.15 | |
| Hindered amine-based photostabilizer 6 | | | | | | | | | 0.2 | | |
| Oxidant inhibitor 1 | 0.1 | 0.05 | 0.1 | 0.1 | 0.1 | 0.1 | 0.1 | 0.1 | 0.05 | 0.1 | 0.1 |
| Oxidant inhibitor 2 | 0.1 | 0.1 | 0.1 | 0.1 | 0.1 | 0.1 | 0.1 | 0.1 | 0.1 | 0.1 | 0.1 |
| Evaluation | | | | | | | | | | | |
| Preservation stability test | A | A | A | A | A | A | B | C | C | A | A |
| Specific Volume Resistivity at 60°C [Ω·cm] | 3.1x10¹⁵ | 4.4x10¹⁶ | 4.4x10¹⁶ | 2.1x10¹⁶ | 1.5x10¹⁷ | 5.0x10¹⁶ | 3.8x10¹⁶ | 2.2x10¹⁶ | 5.1x10¹⁶ | 3.2x10¹⁶ | 3.5x10¹⁵ |

| | | | | | | | | | | | |
|---|---|---|---|---|---|---|---|---|---|---|---|
| *Reference Examples Hindered amine-based photostabilizer 1 (pH=8.7): compound indicated by Formula (1) (bis(1,2,2,6,6-pentamethyl-4-piperidyl)sebacate) Hindered amine-based photostabilizer 2 (pH=8.3): compound indicated by Formula (2) (1,2,2,6,6-pentamethyl-4-piperidyl methacrylate) Hindered amine-based photostabilizer 3 (pH=8.1): compound indicated by Formula (3) (decane diacid bis(2,2,6,6-tetramethyl-1-(octyloxy)-4-piperidinyl)ester) Hindered amine-based photostabilizer 4 (pH=8.7): compound indicated by Formula (4) (1,6-hexanediamine, N,N'-bis(1,2,2,6,6-pentamethyl-4-piperidyl)-, polymer with morpholine-2,4,6-trichloro-1,3,5-triazine) Hindered amine-based photostabilizer 5 (pH=9.9): bis(2,2,6,6-tetramethyl-4-piperidyl)sebacate Hindered amine-based photostabilizer 6 (pH=9.2): 3-(2,2,6,6-tetramethyl-4-piperidinyl)-2-methyl-1-propene-3-one | | | | | | | | | | | |

As apparent from Table 2, the solar-cell encapsulating material sheets in Examples 1 to 7 using the hindered amine-based photostabilizer of which the pH is equal to or less than 9.0 were excellent in longitudinal stability of adhesion strength.

Solar-cell encapsulating material sheets in Comparative Examples 1 and 2 only using the hindered amine-based photostabilizer of which the pH is more than 9.0 had deteriorated longitudinal stability of adhesion strength.

As apparent from Reference Examples 1 and 2, in a case of using an ethylene·α-olefin copolymer of which the MFR is more than 10 g/10 minutes, regardless of the type of the hindered amine-based photostabilizer, the obtained solar-cell encapsulating material sheet was excellent in longitudinal stability of adhesion strength.

## Claims

1. A resin composition for a solar-cell encapsulating material, comprising:
an ethylene·α-olefin copolymer of which an MFR measured based on ASTM D1238 under conditions of 190°C and a load of 2.16 kg is equal to or more than 2.0 g/10 minutes and equal to or less than 9.0 g/10 minutes;
a silane coupling agent; and
a hindered amine-based photostabilizer,
wherein pH of the hindered amine-based photostabilizer, which is measured by using the following measuring method is equal to or less than 9.0, and
in the measuring method, the pH is measured by using a potential difference measuring device and by using a solution which contains 10 g of acetone, 1 g of water, and 0.01 g of the hindered amine-based photostabilizer, and
wherein the hindered amine-based photostabilizer includes one type, or two or more types which are selected from a group consisting of compounds indicated by the following Formulae (1) to (4).

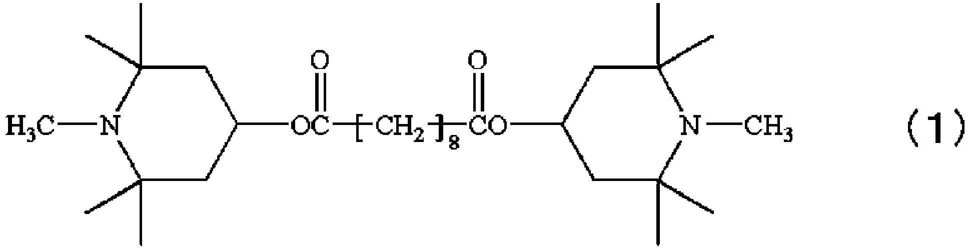

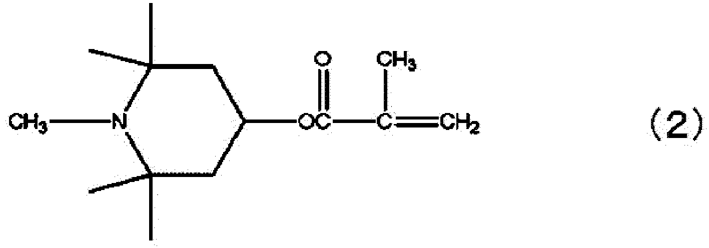

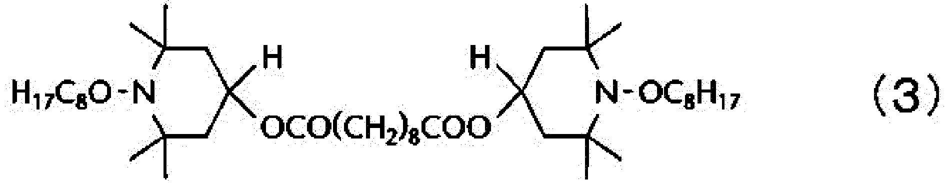

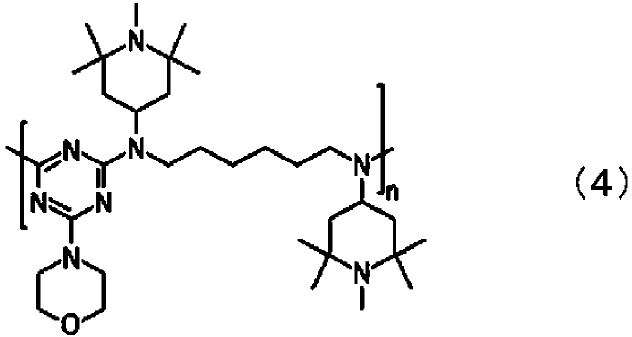

2. The resin composition for a solar-cell encapsulating material according to claim 1,
wherein the ethylene·α-olefin copolymer further satisfies the following requirements a1) to a3).
a1) a content percentage of a constituent unit derived from ethylene is 80 to 90 mol%, and a content percentage of a constituent unit derived from α-olefin having 3 to 20 carbon atoms is 10 to 20 mol%
a2) density measured based on ASTM D1505 is 0.865 to 0.884 g/cm³
a3) Shore A hardness measured based on ASTM D2240 is 60 to 85

3. The resin composition for a solar-cell encapsulating material according to claim 1 or 2,
wherein a content of the hindered amine-based photostabilizer in the resin composition for a solar-cell encapsulating material is equal to or more than 0.01 parts by mass and equal to or less than 1 part by mass, with respect to 100 parts by mass of the ethylene·α-olefin copolymer.

4. The resin composition for a solar-cell encapsulating material according to any one of claims 1 to 3,
wherein a content of the silane coupling agent in the resin composition for a solar-cell encapsulating material is equal to or more than 0.01 parts by mass and equal to or less than 5 parts by mass, with respect to 100 parts by mass of the ethylene·α-olefin copolymer.

5. The resin composition for a solar-cell encapsulating material according to any one of claims 1 to 4,
wherein the silane coupling agent includes at least one type selected from 3-methacryloxypropyl trimethoxy silane and 3-acryloxypropyl trimethoxy silane.

6. A solar-cell encapsulating material formed of the resin composition for a solar-cell encapsulating material according to any one of claims 1 to 5.

7. The solar-cell encapsulating material according to claim 6, which has a sheet shape.

8. The solar-cell encapsulating material according to claim 6 or 7,
wherein a specific volume resistivity of the cross-linked solar-cell encapsulating material, which is measured at a temperature of 60°C and an applied voltage of 1000 V, based on JIS K6911 is equal to or more than 1.0X10¹⁶ Ω·cm.

9. A solar cell module comprising:
a front surface-side transparent protection member;
a back surface-side protection member;
a solar cell element; and
an encapsulating layer which is formed by performing crosslinking on the solar-cell encapsulating material according to any one of claims 6 to 8, and encapsulates the solar cell element between the front surface-side transparent protection member and the back surface-side protection member.

## Patentansprüche

1. Harzzusammensetzung für ein Solarzelleinkapselmaterial, enthaltend:
ein Ethylen-α-Olefin-Copolymer, bei dem ein MFR, gemessen auf der Basis von ASTM D1238 unter Bedingungen von 190°C und einer Beladung von 2,16 kg, gleich oder mehr als 2,0 g/10 min und gleich oder weniger als 9,0 g/10 min ist,
ein Silankupplungsmittel und
einen Fotostabilisator auf Basis von gehindertem Amin,
worin der pH des Fotostabilisators auf Basis von gehindertem Amin, gemessen unter Verwendung des folgenden Messverfahrens, gleich oder weniger als 9,0 ist, und
worin in dem Messverfahren der pH unter Verwendung einer Potentialdifferenzmessvorrichtung und durch Verwendung einer Lösung gemessen wird, die 10 g Aceton, 1 g Wasser und 0,01 g des Fotostabilisators auf Basis des gehinderten Amins enthält, und
worin der Fotostabilisator auf Basis des gehinderten Amins einen Typ oder zwei oder mehrere Typen enthält, ausgewählt aus der Gruppe, bestehend aus Verbindungen, angezeigt durch die folgenden Formeln (1) bis (4)

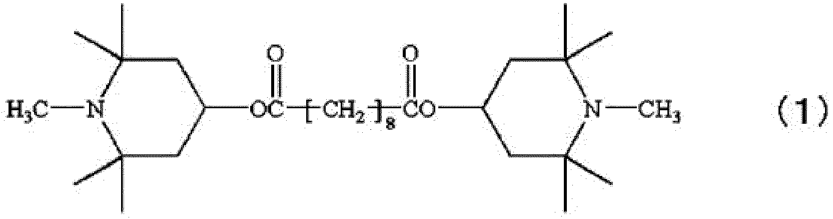

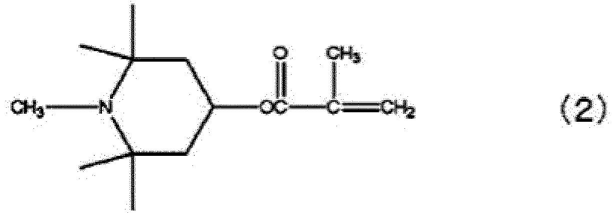

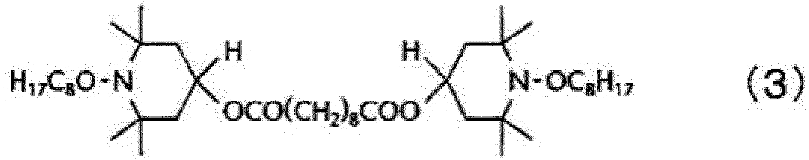

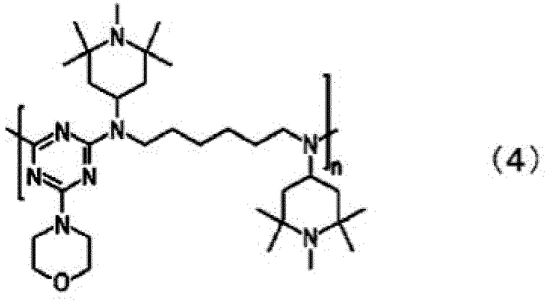

2. Harzzusammensetzung für ein Solarzelleinkapselmaterial gemäß Anspruch 1,
worin das Ethylen-α-Olefin-Copolymer weiterhin die folgenden Erfordernisse a1) bis a3) erfüllt:
a1) ein Prozentsatz des Gehaltes einer Bestandteilseinheit, die von Ethylen stammt, ist 80 bis 90 mol-% und ein Prozentsatz des Gehaltes einer Bestandteilseinheit, die von α-Olefin mit 3 bis 20 Kohlenstoffatomen stammt, ist 10 bis 20 mol-%,
a2) die Dichte, gemessen auf der Basis von ASTM D1505, ist 0,865 bis 0,884 g/cm³,
a3) die Shore A-Härte, gemessen auf der Basis von ASTM D2240, ist 60 bis 85.

3. Harzzusammensetzung für ein Solarzelleinkapselmaterial gemäß Anspruch 1 oder 2, worin ein Gehalt des Fotostabilisators auf Basis von gehindertem Amin in der Harzzusammensetzung für ein Solarzelleinkapselmaterial gleich oder mehr als 0,01 Masseteile und gleich oder weniger als 1 Masseteil ist in Bezug auf 100 Masseteile des Ethylen-α-Olefin-Copolymers.

4. Harzzusammensetzung für ein Solarzelleinkapselmaterial gemäß einem der Ansprüche 1 bis 3, worin ein Gehalt des Silankupplungsmittels in der Harzzusammensetzung für ein Solarzelleinkapselmaterial gleich oder mehr als 0,01 Masseteile und gleich oder weniger als 5 Masseteile in Bezug auf 100 Masseteile des Ethylen-α-Olefin-Copolymers ist.

5. Harzzusammensetzung für ein Solarzelleinkapselmaterial gemäß einem der Ansprüche 1 bis 4, worin das Silankupplungsmittel zumindest einen Typ enthält, ausgewählt aus 3-Methacryloxypropyltrimethoxysilan und 3-Acryloxypropyltrimethoxysilan.

6. Solarzelleinkapselmaterial, gebildet aus der Harzzusammensetzung für ein Solarzelleinkapselmaterial gemäß einem der Ansprüche 1 bis 5.

7. Solarzelleinkapselmaterial gemäß Anspruch 6, das eine Lagenform hat.

8. Solarzelleinkapselmaterial gemäß Anspruch 6 oder 7, worin ein spezifischer Volumenwiderstand des vernetzten Solarzelleinkapselmaterials, gemessen bei einer Temperatur von 60°C und einer auferlegten Spannung von 1.000 V auf der Basis von JIS K6911, gleich oder mehr als 1,0×10¹⁶ Ω·cm ist.

9. Solarzellmodul, enthaltend:
ein transparentes Schutzteil für die Vorderoberflächenseite,
ein Schutzteil für die Rückoberflächenseite,
ein Solarzellelement und
eine Einkapselungsschicht, die gebildet ist durch Durchführen einer Vernetzung des Solarzelleinkapselmaterials gemäß einem der Ansprüche 6 bis 8, und die das Solarzellelement zwischen dem transparenten Schutzteil für die vordere Oberflächenseite und dem Schutzteil für die Rückoberflächenseite einkapselt.

## Revendications

1. Composition de résine pour un matériau de scellement de cellule solaire, comprenant :
un copolymère d'éthylène/α-oléfine dont un indice de fluidité (MFR), mesuré conformément à l'ASTM D1238 à 190 °C et sous des conditions de charge de 2,16 kg, est supérieur ou égal à 2,0 g/10 minutes et inférieur ou égal à 9,0 g/10 minutes ;
un agent adhésif au silane ; et
un photostabilisant à base d'amine encombrée,
dans laquelle le pH du photostabilisant à base d'amine encombrée, qui est mesuré au moyen du procédé de mesure suivant, est inférieur ou égal à 9,0, et
dans le procédé de mesure, le pH est mesuré au moyen d'un dispositif de mesure de différence de potentiel et au moyen d'une solution qui contient 10 g d'acétone, 1 g d'eau et 0,01 g du photostabilisant à base d'amine encombrée, et
dans laquelle le photostabilisant à base d'amine encombrée inclut un type, ou deux types ou plus qui sont choisis dans un groupe constitué de composés indiqués par les formules (1) à (4) suivantes.

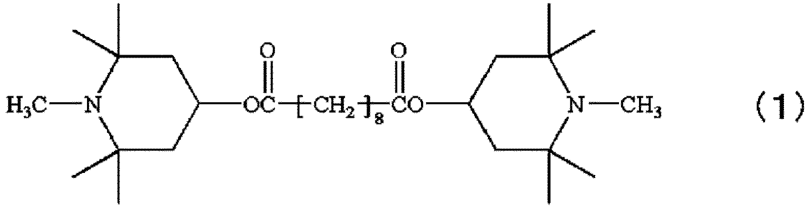

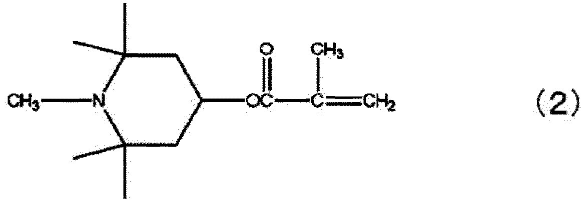

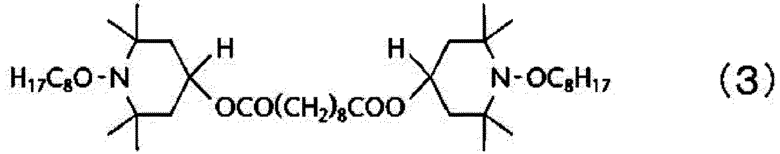

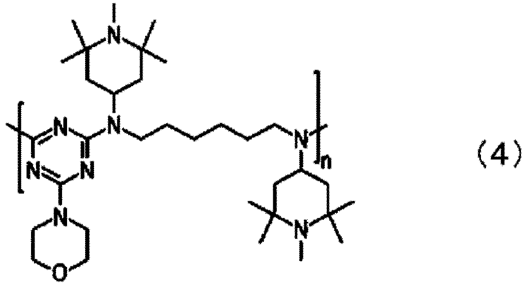

2. Composition de résine pour un matériau de scellement de cellule solaire selon la revendication 1,
dans laquelle le copolymère d'éthylène/α-oléfine satisfait en outre les exigences a1) à a3) suivantes.
a1) une teneur en pourcentage d'une unité constituante dérivée d'éthylène est 80 à 90 % mol, et une teneur en pourcentage d'une unité constituante dérivée d'a-oléfine présentant 3 à 20 atomes de carbone est de 10 à 20 % mol,
a2) la densité mesurée conformément à l'ASTM D1505 est de 0,865 à 0,884 g/cm³,
a3) la dureté Shore A mesurée conformément à l'ASTM D2240 est de 60 à 85.

3. Composition de résine pour un matériau de scellage de cellule solaire selon la revendication 1 ou 2,
dans laquelle une teneur du photostabilisant à base d'amine encombrée dans la composition de résine pour un matériau de scellage de cellule solaire est supérieure ou égale à 0,01 partie en masse et inférieure ou égale à 1 partie en masse, par rapport à 100 parties en masse du copolymère d'éthylène/α-oléfine.

4. Composition de résine pour un matériau de scellage de cellule solaire selon l'une quelconque des revendications 1 à 3,
dans laquelle une teneur de l'agent adhésif au silane dans la composition de résine pour un matériau de scellage de cellule solaire est supérieure ou égale à 0,01 partie en masse et inférieure ou égale à 5 parties en masse, par rapport à 100 parties en masse du copolymère d'éthylène/α-oléfine.

5. Composition de résine pour un matériau de scellage de cellule solaire selon l'une quelconque des revendications 1 à 4,
dans laquelle l'agent adhésif au silane inclut au moins un type choisi parmi triméthoxysilane de 3-méthacryloxypropyle et triméthoxysilane de 3-acryloxypropyle.

6. Matériau de scellage de cellule solaire formé de la composition de résine pour un matériau de scellage de cellule solaire selon l'une quelconque des revendications 1 à 5.

7. Matériau de scellage de cellule solaire selon la revendication 6, qui présente une forme de feuille.

8. Matériau de scellage de cellule solaire selon la revendication 6 ou 7,
dans lequel une résistivité volumique spécifique du matériau de scellage de cellule solaire réticulé, qui est mesurée à une température de 60 °C et à une tension appliquée de 1 000 V, conformément à JIS K6911, est supérieure ou égale à 1,0 x 10¹⁶ Ω·cm.

9. Module de cellule solaire comprenant :
un élément de protection transparent côté surface avant ;
un élément de protection côté surface arrière ;
un élément formant cellule solaire ; et
une couche de scellage qui est formée en réalisant une réticulation sur le matériau de scellage de cellule solaire selon l'une quelconque des revendications 6 à 8, et scelle l'élément formant cellule solaire entre l'élément de protection transparent côté surface avant et l'élément de protection côté surface arrière.
